# EUROPÄISCHE PATENTSCHRIFT

(11) **EP 1 132 957 B1**
(45) Veröffentlichungstag und Bekanntmachung des Hinweises auf die Patenterteilung: **22.08.2007**
(21) Anmeldenummer: 01103715.7
(22) Anmeldetag: 15.02.2001
(51) Int. Cl.: H01L 21/768, H01L 21/3213, H01L 23/532

(54) **Verfahren zur Herstellung einer Leiterstruktur für einen integrierten Schaltkreis**
Process for the fabrication of a conductive structure for an integrated circuit
Procédé pour la fabrication d'une structure conductrice pour un circuit intégré

(30) Priorität: 07.03.2000 DE 10011886
(43) Veröffentlichungstag der Anmeldung: 12.09.2001
(73) Patentinhaber: Infineon Technologies AG, 81669 München (DE)
(72) Erfinder: Wege, Stephan, 01474 Weissig (DE); Moll, Peter, 01099 Dresden (DE)
(74) Vertreter: Patentanwaltskanzlei WILHELM & BECK

(56) Entgegenhaltungen:
- US-A- 4 742 014
- US-A- 5 670 420
- US-A- 6 010 603
- US-A- 6 027 860

## Beschreibung

Die Erfindung betrifft ein Verfahren zur Herstellung einer Leiterstruktur für einen integrierten Schaltkreis. Die Strukturen derartiger integrierter Schaltkreise bewegen sich dabei im Sub-Mikron-Bereich. Integrierte Schaltkreise weisen eine auf einem gemeinsamen Träger (Substrat) aufgebrachte mikroelektronische Schaltung mit einer Vielzahl von Bauelementen auf. Der Integrationsgrad, ein Maß für die Anzahl der elektronischen Bauelemente auf dem Chip, kann bei VLSI (very large scale integration), ULSI (ultra large scale integration) oder höher liegen.

Insbesondere bei der Herstellung der Metallebenen eines integrierten elektronischen Schaltkreises ergeben sich mannigfaltige Probleme. Wird die Metallebene mit Kupfer realisiert, besteht beim Strukturieren des Kupfers die Gefahr der Korrosion. Diese entsteht dadurch, dass nach dem Ätzen des Kupfers Rückstände des Ätzmaterials die offenliegenden Kupferflächen angreifen. Weiterhin kommt nachteilhafterweise hinzu, dass sich Kupfer bei chemischem Ätzen nur bei Temperaturen entfernen läst, bei denen der Photolack verfließt oder gar verbrennt.

Aus dem Stand der Technik US 4.026.742 ist ein Plasmaätzverfahren zur Herstellung eines integrierten Schaltkreises bekannt. Auch dort besteht das Problem, wenn flüssige Ätzlösungen verwendet werden, dass die Ätzmaske, welche aus einem photoresistiven Material hergestellt ist, verschwindet oder während des Ätzens abblättert, so dass eine präzise Strukturierung schwierig ist. Beim Stand der Technik US 4.026.742 wird zur Lösung dieses Problems vorgeschlagen, zur Herstellung des integrierten Schaltkreises in der Reaktionskammer ein Gas, das eine Halogenkomponente aufweist, in einem Plasmazustand mit einem hochfrequenten elektromagnetischen Feld zu verwenden. Die halogenierten Metallbereiche werden durch Sublimation, Verdunstung oder Abwaschen mit Wasser oder einer anderen geeigneten Lösung entfernt. Dabei wird das bloßgelegte Metall mit einem reaktiven halogenierten Gas im Plasmazustand in ein Metallhalid umgewandelt und entfernt, um das elektrisch leitende Metall zu strukturieren. Das Plasma kann in einer Reaktionskammer mit einem hochfrequenten elektromagnetischen Feld erzeugt werden. Das Verfahren dient zur Erzeugung der gewünschten Struktur des Metalls für Elektroden oder Leitungen auf dem Halbleitersubstrat oder anderen mikroelektrischen Trägern. Es wird insbesondere zur Ätzung von Wolfram oder Molybdäniummetallstrukturen verwendet. Das halogenierte Gas beinhaltet im wesentlichen die Dichlordifluormethan. Die Stromquelle arbeitet mit einem Strom von 180 mA bei 1200 V und einer Frequenz von 13,56 MHz. Da das Plasma bei mehr als 10.000°Celsius besteht, muss das Kammermaterial entsprechend ausgelegt sein, um den stattfindenden Reaktionen widerstehen zu können. Nachteilhafterweise sind hierbei besondere Anforderungen an die Reaktionskammer zu stellen.

Aus dem Stand der Technik US 5.817.572 ist ein weiteres Verfahren zur Herstellung von Anschlüssen zwischen Anschlusskanälen bekannt. In dieser Druckschrift wird auch der dual damascene Prozess beschrieben. Eine dielektrische Schicht wird abgeschieden und mittels eines zweistufigen Ätzprozesses strukturiert. In der ersten Stufe des Ätzprozesses wird der größte Teil der dielektrischen Schicht innerhalb der Kontaktöffnungen abgeätzt. Im zweiten Schritt werden die Anschlusskanäle und der Rest der dielektrischen Schicht innerhalb der Kontaktöffnungen abgeätzt. Die Tiefe der Anschlusskanäle ist wegen der Filmabscheidung und der ungleichen Abätzung schwierig zu steuern. Die Tiefe der Anschlusskanäle kann im Zentrum des Wafers zu groß und am Rand des Wafers zu gering sein. Daraus entstehen große Unterschiede bei den Anschlusswiderständen auf ein und demselben Wafer. Die Metallabscheidung ist schwierig, da die Kontaktöffnungen ein Seitenverhältnis (Verhältnis von Höhe zu Breite) von 2:1, 3:1 oder mehr haben können. Die großen Seitenverhältnisse machen eine Sputterabscheidung nahezu unmöglich. Eine Metallschicht kann durch chemical vapor deposition innerhalb der Kontaktöffnungen und der Anschlusskanäle abgeschieden werden. Dennoch werden Anschlussmaterialien wie Aluminium, Kupfer, Gold und Silber typischer Weise nicht mit chemical vapor deposition abgeschieden. Polysilizium und Wolfram können jedoch mit chemical vapor deposition abgeschieden werden. Damit ist der dual damascene Prozess zur Herstellung der gewünschten Leiterstruktur für einen integrierten Schaltkreis wenig geeignet.

Aus der US 5,670,420 ist ein Verfahren zur Herstellung einer Leiterbahnstruktur mit den Merkmalen des Oberbegriffes des Anspruchs 1 bekannt. Aus der US 6,027,860 ist weiterhin ein Verfahren zum Ausbilden einer dreidimensionalen Stapelkondensatorsstruktur bekannt, bei der die Kondensatorstruktur durch Wiederabscheiden von abgeätztem Kondensatormaterial erzeugt wird.

Eine Aufgabe der Erfindung ist es, ein Verfahren zur Herstellung einer Leiterstruktur für einen integrierten Schaltkreis anzugeben, bei dem die Passivierung der Metallschicht einfach und mit nur wenigen Prozessschritten möglich ist. Weiterhin sollen die im obengenannten Stand der Technik aufgezeigten Nachteile vermieden werden.

Die Aufgabe wird durch das erfindungsgemäße Verfahren zur Herstellung einer Leiterstruktur für einen integrierten Schaltkreis mit den in Patentanspruch 1 angegebenen Merkmalen gelöst.

Vorteilhafte Weiterbildungen der Erfindung ergeben sich aus den in den abhängigen Patentansprüchen angegebenen Merkmalen.

Das erfindungsgemäße Verfahren zur Herstellung einer Leiterstruktur für einen integrierten Schaltkreis weist eine strukturierte erste Isolierschicht auf, auf die eine erste Passivierungsschicht aufgebracht wird. Auf die erste Passivierungsschicht wird eine Schicht leitenden Materials aufgebracht, auf welcher wiederum eine zweite Passivierungsschicht aufgebracht wird. Auf dieser wird eine Hartmaske aufgebracht. Anschließend wird die Schicht leitenden Materials in den durch die Hartmaske vorgesehenen Bereichen entfernt. Die erste Passivierungsschicht wird in den durch die Hartmaske vorgesehenen Bereichen durch Sputtern entfernt und an der Seitenwand des leitenden Materials wenigstens zum Teil wieder abgelagert.

Das Entfernen der Schicht leitenden Materials kann durch reaktives Ionenätzen erfolgen.

Das Entfernen der Schicht leitenden Materials kann auch durch Sputtern erfolgen.

Die Schicht leitenden Materials weist vorteilhafterweise Kupfer auf. Kupfer hat einen relativ geringen ohmschen Widerstand.

Die Schichtstärke des leitenden Materials liegt zwischen 300 nm und 500nm.

Die Passivierungsschichten können Tantal, Tantalnitrid oder beides aufweisen.

Vorteilhafterweise weist die erste Isolierschicht ein Siliziumoxid oder ein Material mit einer Dielektrizitätskonstante, die niedriger als die von Siliziumoxid ist, auf.

Die Hartmaske kann Siliziumnitrid, Siliziumoxinitrid oder Siliziumoxid aufweisen.

Günstigerweise liegt die Dicke der Hartmaske zwischen 100 nm und 300 nm.

Vorteilhafterweise beträgt die Dicke der ersten und der zweiten Passivierungsschicht jeweils annähernd 20 nm.

Die Oberfläche kann mit einer dritten Passivierungsschicht versehen werden.

Die Oberfläche kann auch mit einer zweiten Isolierschicht versehen werden.

Wird die Oberfläche mit einer zweiten Isolierschicht versehen, so ist sie anschließend chemisch mechanisch zu polieren.

Vorteilhafterweise wird beim Sputtern der Wafer gekühlt.

Es ist weiterhin von Vorteil, beim Sputtern Stickstoff zuzuführen.

Die strukturierte erste Isolierschicht kann durch reaktive Ionenätzung erzeugt werden.

Die Strukturierung der Schicht leitenden Materials kann durch ein Aufheizen des Wafers und ein anschließendes reaktives Ionenätzen erfolgen.

Die Hartmaske kann dadurch erzeugt werden, dass zuerst das Hartmaskenmaterial mittels chemical vapor deposition abgeschieden wird. Anschließend wird eine Antireflexschicht aufgebracht, über der eine Photolackmaske aufgebracht wird. Das Hartmaskenmaterial wird dann an den durch die Photolackmaske vorgesehenen Bereichen abgeätzt. Schließlich werden die Antireflexschicht sowie die Photolackmaske entfernt.

Die Erfindung wird im folgenden anhand mehrerer Figuren weiter erläutert. Sämtliche Figuren sind Querschnittdarstellungen.
- Figur 1: zeigt den Schichtaufbau mit Substrat, Isolierschicht, Antireflexschicht und Photolack und bereits vorhandenem Kontaktierungsloch.
- Figur 2: zeigt den Schichtaufbau nach dem Entfernen der Photolackschicht und der Antireflexschicht und bereits aufgebrachter erster Passivierungsschicht.
- Figur 3: zeigt den Schichtaufbau mit Metallfüllung des Kontaktierungslochs und der zweiten Passivierungsschicht.
- Figur 4: zeigt den Schichtaufbau mit zusätzlich abgeschiedenem Hartmaskenmaterial.
- Figur 5: zeigt den Schichtaufbau mit aufgebrachter Antireflexschicht und Photolackmaske.
- Figur 6: zeigt den Schichtaufbau mit bereits strukturierter Hartmaske.
- Figur 7: zeigt den Schichtaufbau nach dem Entfernen der Photolackmaske und der Antireflexschicht.
- Figur 8: zeigt den Schichtaufbau nach dem teilweisen Entfernen der zweiten Passivierungsschicht, der Metallschicht und der ersten Passivierungsschicht sowie der Ablagerung der Passivierungsschicht an den Seitenwänden.
- Figur 9: zeigt den Schichtaufbau mit optionaler dritter Passivierungsschicht.
- Figur 10: zeigt den Schichtaufbau mit optionaler Passivierungsschicht und einer zweiten Isolierschicht.
- Figur 11: zeigt den Schichtaufbau nach chemisch mechanischem Polieren.
- Figur 12: zeigt den Schichtaufbau mit optionaler Passivierungsschicht und einer dritten Isolierschicht.

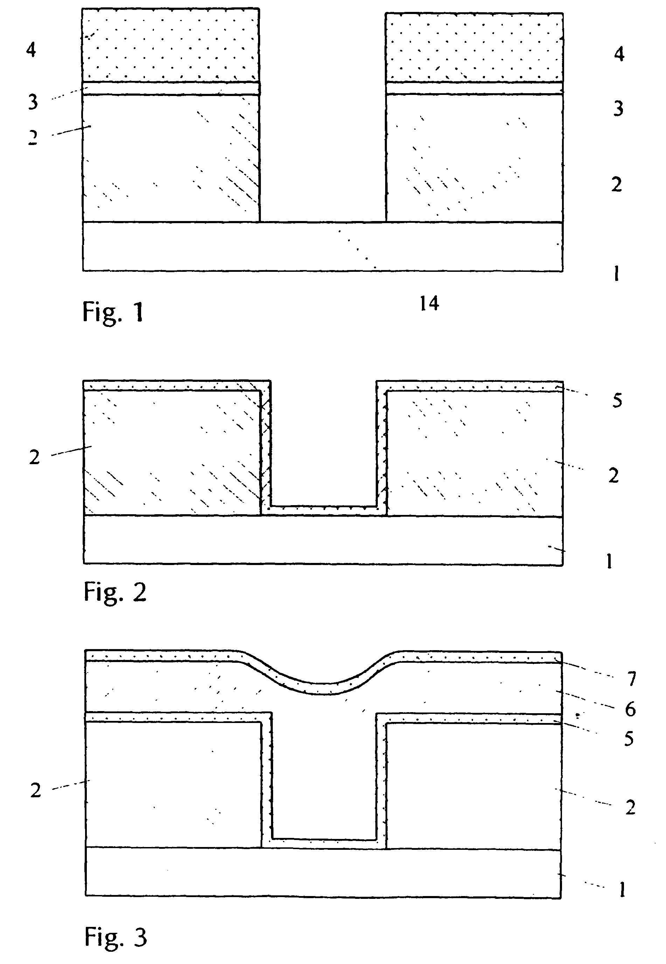

In Figur 1 ist der Schichtaufbau im Querschnitt gezeigt, wobei auf ein Substrat 1 eine erste Isolierschicht 2 aufgebracht ist. Oberhalb der ersten Isolierschicht 2 ist eine Antireflexschicht 3 gezeigt, welche von einer Photolackschicht 4 bedeckt ist. In den durch die Photomaske 4 vorgesehenen Bereichen wurde bereits die Antireflexschicht 3 und die erste Isolierschicht 2 entfernt, so dass dadurch ein Kontaktierungsloch (via) 14 gebildet wird. Die Entfernung der ersten Isolierschicht 2 erfolgt mittels herkömmlichem Ätzverfahren.

Als erste Photolackschicht 4 kann Material verwendet werden, das für eine Lithographie im tiefen UV-Bereich geeignet ist.

Die Antireflexschicht 3 dient bei der Belichtung zur Vermeidung von Reflexionen am Untergrund, im vorliegenden Fall an der ersten Isolierschicht 2.

Die erste Isolierschicht 2 ist ein Dielektrikum, welches ein Oxid aufweist.

Der Graben in der Isolierschicht 2 weist horizontal eine Breite von zirka 200 nm und vertikal eine Höhe von zirka 600 nm auf, was der Stärke der ersten Isolierschicht 2 entspricht.

Nachdem die Photolackschicht 4 und die Antireflexschicht 3 entfernt sind, wird entsprechend Figur 2 eine erste Passivierungsschicht 5 aufgebracht.

Die erste Passivierungsschicht 5 hat eine Stärke von zirka 20 nm und dient zur Vermeidung der Korrosion des Kupfers, welche entstehen würde, wenn das Kupfer mit der Isolierschicht 2 in Verbindung käme. Diese erste Passivierungsschicht 5 dient gleichzeitig als Diffusionsbarriere. Die erste Passivierungsschicht 5 (liner) kann Tantal Ta, Tantalnitrid TaN oder auch beide Materialien aufweisen. Die erste Passivierungsschicht 5 bedeckt gemäß Figur 2 sowohl die erste Isolierschicht 2 als auch den Bereich des Substrats 1, in dem die erste Isolierschicht 2 entfernt wurde.

Im nächsten Prozessschritt wird, wie in Figur 3 gezeigt, eine Metallschicht 6 aus Kupfer Cu auf die erste Isolierschicht 5 aufgebracht. Durch die erste Passivierungsschicht 5 ist die Metallschicht 6 von der ersten Isolierschicht 2 völlig getrennt. Dadurch wird, wie bereits erwähnt, eine Korrosion des Kupfers vermieden. Zusätzlich wird oberhalb der Metallschicht 6 eine zweite Passivierungsschicht 7, die auch als Diffusionsbarriere dient, aufgebracht.

Die Metallschicht 6 ist zwischen 300 nm und 500 nm, vorzugsweise annähernd 350 nm dick. Die zweite Passivierungsschicht 7 weist in etwa die gleiche Stärke wie die erste Passivierungsschicht 2 auf, nämlich annähernd 20 nm. Auch in der Materialzusammensetzung kann die zweite Passivierungsschicht 7 der ersten Passivierungsschicht 5 entsprechen.

Die Metallschicht 6 kann durch Elektroplating aufgebracht werden. Als Metall wird Kupfer verwendet. Kupfer hat den Vorteil, dass es einen relativ niedrigen ohmschen Widerstand aufweist.

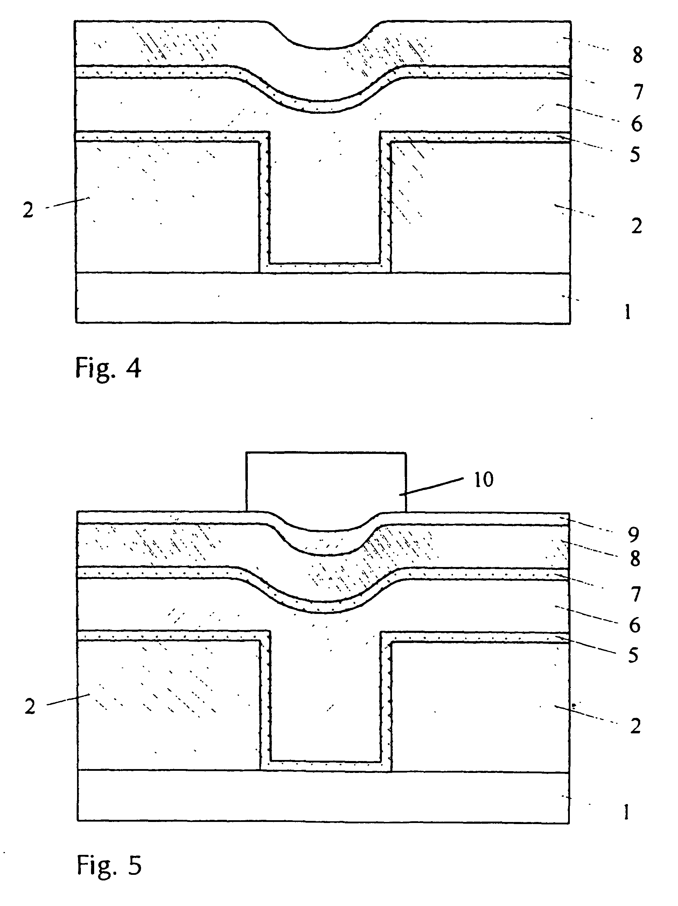

Bei dem in Figur 4 gezeigten Schichtaufbau ist oberhalb der zweiten Passivierungsschicht 7 eine Schicht 8 mit einer Schichtstärke mit zirka 250 nm aufgebracht worden. Diese Schicht 8 dient nach der Strukturierung als Hartmaske. Als Material kommt Siliziumnitrid oder Siliziumoxinitrid in Frage. Die Abscheidung des Hartmaskenmaterials 8 kann durch chemical vapor deposition (CVD) erfolgen.

In einem weiteren Prozessschritt wird gemäß Figur 5 über der Schicht 8 eine Antireflexschicht 9 aufgebracht, die unter anderem auch die Tiefe der Delle im mittleren Bereich der Schicht 8 reduziert. Als Antireflexschicht 8 kommt vorteilhafterweise organisches Material zur Verwendung. Oberhalb der Antireflexschicht 9 ist eine Photomaske 10 aus Photolack angeordnet.

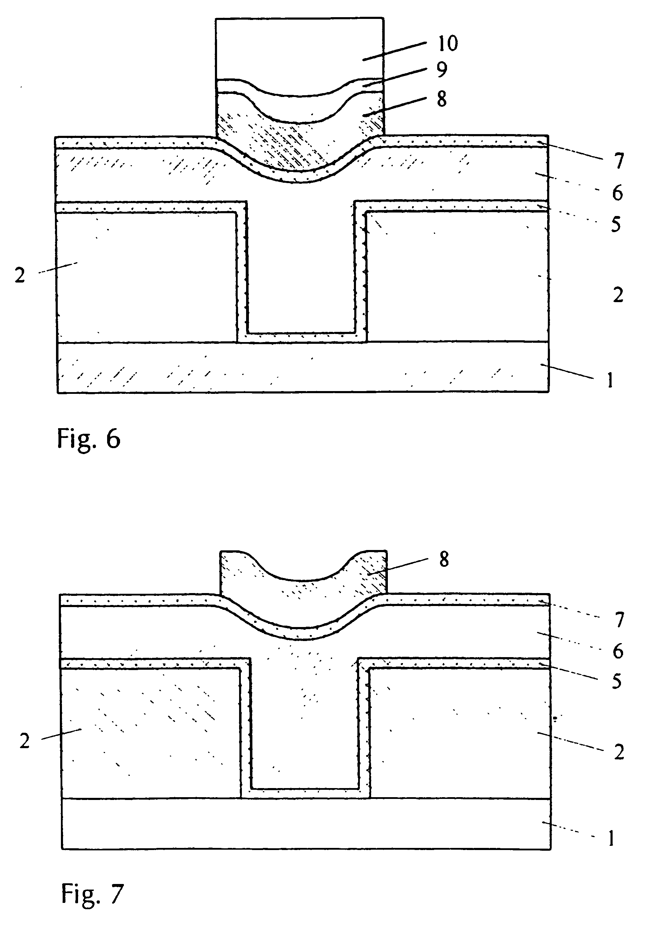

Nachdem die Antireflexschicht 9 und die Schicht 8 in den durch die Photomaske 10 vorgesehenen Bereichen durch Ätzen entfernt wurden, ergibt sich der in Figur 6 gezeigte Schichtaufbau. Die Ätzung erfolgt solange, bis die zweite Passivierungsschicht 7 erreicht ist. Dabei darf die zweite Passivierungsschicht 7 nicht durchgeätzt werden.

Anschließend werden die Photomaske 10 und die Antireflexschicht 9 entfernt. Damit ergibt sich der in Figur 7 gezeigte Schichtaufbau. Das Entfernen der Photomaske 10 und der Antireflexschicht 9 erfolgt durch Trockenstrip ohne Nassreinigung.

In einem weiteren Prozessschritt wird die zweite Passivierungsschicht 7 sowie die Metallschicht 6 in den durch die Hartmaske vorgegebenen Bereichen entfernt. Das Entfernen der zweiten Passivierungsschicht 7 und der Metallschicht 6 kann durch reaktives Ionenätzen oder auch durch Sputtern erfolgen.

Die Strukturierung der Kupfermetallschicht 6 mittels reaktivem Ionenätzen (RIE) kann mit Ätzgasen, wie zum Beispiel Salzsäure HCl oder Chlor Cl2 unterstützt durch Argon Ar oder Xenon Xe erfolgen.

Die erste Passivierungsschicht 5 wird durch Ionenbeschuss (Sputtern) von der ersten Isolierschicht 2 abgesputtert und wenigstens teilweise als Seitenwandpassivierung 52 an den seitlichen Bereich der Metallschicht 6, der zweiten Isolierschicht 7 und der Hartmaske 8 aufgesputtert. Dadurch wird erreicht, dass die Seitenwände durch den Sputterbeschuß gereinigt werden und eine gute Passivierung der Seitenwände durch rückgesputtertes Passivierungsmaterial erreicht wird. Vor Beginn des Sputterns müssen die chemisch aktiven Komponenten (z.B. Cl2) durch Pumpen aus dem Plasma entfernt werden. Ein gezieltes Kühlen des Wafers verstärkt den Niederschlag des Passivierungsmaterials an den Seitenwänden. Zusätzlich kann Stickstoff zur Absättigung der Ta-Bindungen in der Prozesskammer verwendet werden.

Eine Passivierung der Seitenwände kann während der Ätzung durch Zusatz eines Additivs erfolgen. Als Additiv kann anorganisches Material, wie zum Beispiel Stickstoff N2 oder Sauerstoff 02 verwendet werden. Als organische Material kommt CHF3 oder CH4 zur Verwendung.

Diese Passivierungsschicht muss während des Sputterschritts wieder entfernt werden.

Bei Schichtabtragung ist zu berücksichtigen, dass die Dicke der Hartmaske 8 dadurch reduziert wird.

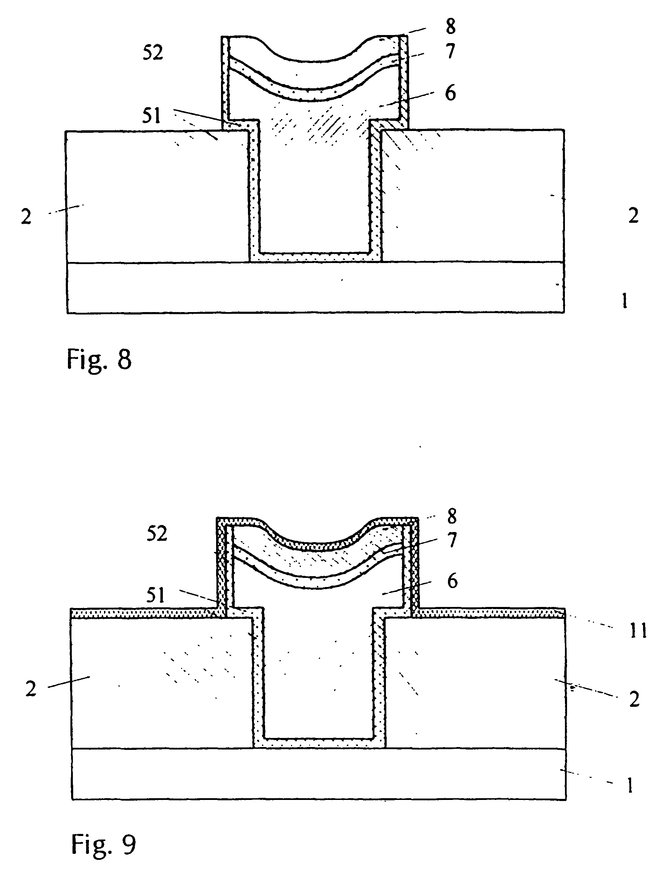

Mit 51 sind in Figur 8 die Teile der ersten Passivierungsschicht 1 gekennzeichnet, die nicht abgesputtert werden. Mit 52 ist die neu aufgebrachte Passivierungsschicht an den Seitenwänden gekennzeichnet.

Im Bedarfsfall kann gemäß Figur 9 ein Überzug mit einer dritten Passivierungsschicht 11 erfolgen. Die dritte Passivierungsschicht 11 bedeckt dabei Teile der ersten Isolierschicht 2, Teile der ersten Passivierungsschicht 5 sowie die Hartmaske 8.

Die dritte Passivierungsschicht 11 hat eine Schichtstärke von zirka 30 nm und kann Siliziumnitrid aufweisen. Die dritte Passivierungsschicht 11 ist nur dann erforderlich, wenn die Passivierungsschicht 52 nicht ausreicht.

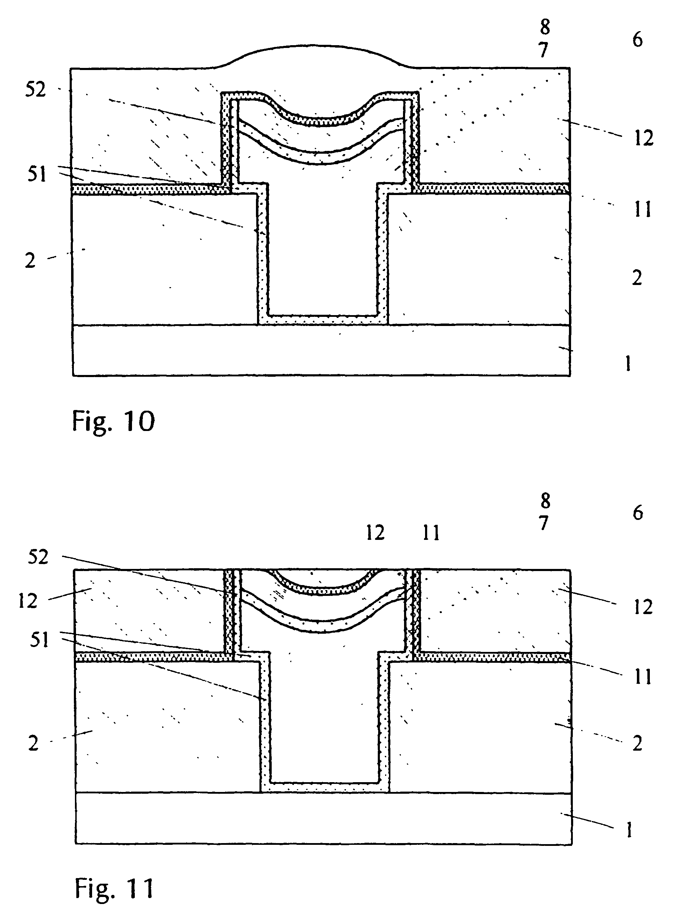

In Figur 10 ist über der optionalen Passivierungsschicht 11 eine zweite Isolierschicht 12 aufgebracht worden.

Die zweite Isolierschicht 12 ist ebenfalls ein Dielektrikum, beispielsweise ein Siliziumoxid oder ein Material, dessen Dielektrizitätskonstante niedriger als die von Siliziumoxid ist, und weist eine Schichtstärke von annähernd 600 nm auf.

Um die zweite Isolierschicht 12 zu planarisieren, wird diese chemisch mechanisch poliert (CMP), so dass ein wie in Figur 11 gezeigter Schichtaufbau entsteht.

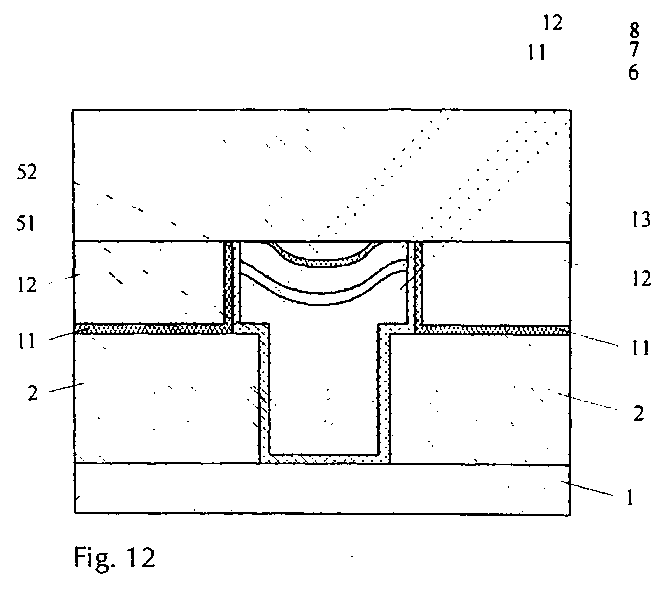

Oberhalb der zweiten Isolierschicht 12 kann, wie in Figur 12 gezeigt, eine dritte Isolierschicht 13, welche ebenfalls ein Oxid sein kann, aufgebracht werden. Die dritte Isolierschicht 13 hat eine Schichtstärke von annähernd 600 nm. Die Isolierschicht 13 kann wiederum, wie in Figur 1 gezeigt, strukturiert werden. Damit ist eine Wiederholung der vorgenannten Prozessschritte möglich. Insgesamt kann somit ein integrierter Schaltkreis mit mehreren Metalllagen durch Wiederholung der vorigen Prozessschritte erzeugt werden.

Das erfindungsgemäße Verfahren hat gegenüber dem Dual damascene Verfahren den Vorteil, dass sich bei der Bahnätzung am Kontaktlochrand kein Grad (fence) bildet. Beim Dual damascene Prozess kann dieser Grad nachteilhafter weise zu einem verminderten Metallquerschnitt führen. Damit können sich Zuverlässigkeitsprobleme ergeben, das heißt, dass die Metallleiterbahnen unter Umständen nicht den erforderlichen elektrischen Eigenschaften (geringer ohmscher Widerstand) entsprechen.

Ein weiterer Vorteil des erfindungsgemäßen Verfahrens besteht darin, dass das Ätzen des Kupfers durch ein reaktives Ionenätzen bei einer hohen Temperatur möglich ist, weil die Hartmaske 8 sich nicht verflüchtigt. Die für die reaktive Ionenätzung notwendige Temperatur kann zum Beispiel durch Kathoden-/ ESC-Heizung oder Lampenheizung (zum Beispiel Halogenlampen) des Wafers durch das Top-Fenster der Kammer oder möglicherweise auch von unten erfolgen. Es ist auch möglich die notwendige Temperatur durch ein gezieltes Aufheizen der Waferoberfläche, beispielsweise durch einen Ar/Xe Sputterschritt auf der zweiten Passivierungsschicht 5 mit hoher RF-Leistung und Abschalten der Waferkühlung, zu erzeugen.

Vorteilhafterweise wird durch die sofortige Passivierung der Seitenwände durch die erfindungsgemäße spezielle Prozessführung die kritische Phase für die Korrosion des Kupfers, nämlich der Wafertransfer beziehungsweise die Zeitdauer vom Ätzprozessende bis zur Reinigung und anschließenden Passivierung, vermieden.

In den Figuren 10, 11 und 12 ist die dritte Passivierungsschicht 11 zwar gezeigt, da diese jedoch optional ist, sind die Schichtaufbauten gemäß den Figuren 10, 11 und 12 auch ohne die dritte Passivierungsschicht 12 möglich.

Das erfindungsgemäße Verfahren läst sich ohne weiteres für die verschiedensten Arten von Halbleiterschaltungen verwenden.

## Patentansprüche

1. Verfahren zur Herstellung einer Leiterstruktur für einen integrierten Schaltkreis,
bei dem auf eine strukturierte erste Isolierschicht (2) eine erste Passivierungsschicht (5) aufgebracht wird,
bei dem auf die erste Passivierungsschicht (5) eine Schicht leitenden Materials (6) aufgebracht wird,
bei dem auf die Schicht leitenden Materials (6) eine zweite Passivierungsschicht (7) aufgebracht wird,
bei dem auf die zweite Passivierungsschicht (7) eine Hartmaske (8) aufgebracht wird,
bei dem die Schicht leitenden Materials (6) in den durch die Hartmaske (8) nicht bedeckten Bereichen entfernt wird,
**dadurch gekennzeichnet, dass**
die erste Passivierungsschicht (5) in den durch die Hartmaske (8) nicht bedeckten Bereichen durch Sputtern entfernt und an der Seitenwand der Schicht leitenden Materials (6) wenigstens zum Teil wieder abgelagert wird.

2. Verfahren nach Patentanspruch 1, **dadurch gekennzeichnet, dass** das Entfernen der Schicht leitenden Materials (6) durch reaktives Ionenätzen erfolgt.

3. Verfahren nach Patentanspruch 1, **dadurch gekennzeichnet, dass** das Entfernen der Schicht leitenden Materials (6) durch Sputtern erfolgt.

4. Verfahren nach einem der Patentansprüche 1 bis 3, **dadurch gekennzeichnet, dass** die Schicht leitenden Materials (6) Kupfer aufweist.

5. Verfahren nach einem der Patentansprüche 1 bis 4, **dadurch gekennzeichnet, dass** die Schichtstärke des leitenden Materials (6) zwischen 300 nm und 500 nm beträgt.

6. Verfahren nach einem der Patentansprüche 1 bis 5, **dadurch gekennzeichnet, dass** die Passivierungsschichten (5, 7) Tantal oder Tantalnitrid oder beides aufweisen.

7. Verfahren nach einem der Patentansprüche 1 bis 6, **dadurch gekennzeichnet, dass** die erste Isolierschicht (2) ein Siliziumoxid oder ein Material mit einer Dielektrizitätskonstante, die niedriger als die von Siliziumoxid ist, aufweist.

8. Verfahren nach einem der Patentansprüche 1 bis 7, **dadurch gekennzeichnet, dass** die Hartmaske (8) Siliziumoxid, Siliziumnitrid oder Siliziumoxinitrid aufweist.

9. Verfahren nach einem der Patentansprüche 1 bis 8, **dadurch gekennzeichnet, dass** die Hartmaske (8) annähernd zwischen 100 nm und 300 nm dick ist.

10. Verfahren nach einem der Patentansprüche 1 bis 9, **dadurch gekennzeichnet, dass** die erste und die zweite Passivierungsschicht (5,7) jeweils annähernd 20 nm dick sind.

11. Verfahren nach einem der Patentansprüche 1 bis 10, **dadurch gekennzeichnet, dass** ein dritte Passivierungsschicht (11) aufgebracht wird.

12. Verfahren nach einem der Patentansprüche 1 bis 11, **dadurch gekennzeichnet, dass** eine zweiten Isolierschicht (12) aufgebracht wird.

13. Verfahren nach Patentanspruch 12, **dadurch gekennzeichnet, dass** die zweiten Isolierschicht (12) chemisch mechanisch poliert wird.

14. Verfahren nach einem der Patentansprüche 1 bis 13, **dadurch gekennzeichnet, dass** beim Sputtern der Wafer gekühlt wird.

15. Verfahren nach einem der Patentansprüche 1 bis 14, **dadurch gekennzeichnet, dass** beim Sputtern Stickstoff zugeführt wird.

16. Verfahren nach einem der Patentansprüche 1 bis 15, **dadurch gekennzeichnet, dass** die strukturierte erste Isolierschicht (2) durch reaktive Ionenätzung erzeugt wird.

17. Verfahren nach einem der Patentansprüche 1 bis 16, **dadurch gekennzeichnet, dass** die Strukturierung der Schicht leitenden Materials (6) durch Aufheizen des Wafers und anschließendem reaktiven Ionenätzen erfolgt.

18. Verfahren nach einem der Patentansprüche 1 bis 17, **dadurch gekennzeichnet, dass** die Hartmaske (8) durch folgende Schritte erzeugt wird:
- das Hartmaskenmaterial wird mittels CVD (Chemical Vapor Deposition) abgeschieden,
- eine Antireflexschicht (9) wird aufgebracht,
- eine Photolackmaske (10) wird aufgebracht,
- das Hartmaskenmaterial wird an den durch die Photolackmaske (10) nicht bedeckten Bereichen abgeätzt, und
- die Antireflexschicht (9) und die Photolackmaske (10) werden entfernt.

## Claims

1. Method for manufacturing a conductor structure for an integrated circuit,
in which a first passivation layer (5) is applied to a structured, first insulating layer (2),
in which a layer of conductive material (6) is applied to the first passivation layer (5),
in which a second passivation layer (7) is applied to the layer of conductive material (6),
in which a hard mask (8) is applied to the second passivation layer (7),
in which the layer of conductive material (6) is removed in the regions not covered by means of the hard mask (8),
**characterized in that** the first passivation layer (5) is removed in the regions not covered by means of the hard mask (8) by sputtering and is at least partially deposited again on the side wall of the layer of conductive material (6).

2. Method according to Patent Claim 1, **characterized in that** the layer of conductive material (6) is removed by reactive ion etching.

3. Method according to Patent Claim 1, **characterized in that** the layer of conductive material (6) is removed by sputtering.

4. Method according to one of Patent Claims 1 to 3, **characterized in that** the layer of conductive material (6) comprises copper.

5. Method according to one of Patent Claims 1 to 4, **characterized in that** the thickness of the layer of the conductive material (6) is between 300 nm and 500 nm.

6. Method according to one of Patent Claims 1 to 5, **characterized in that** the passivation layers (5, 7) comprise tantalum or tantalum nitride or both.

7. Method according to one of Patent Claims 1 to 6, **characterized in that** the first insulating layer (2) comprises a silicon oxide or a material with a dielectric constant which is lower than that of silicon oxide.

8. Method according to one of Patent Claims 1 to 7, **characterized in that** the hard mask (8) comprises silicon oxide, silicon nitride or silicon oxynitride.

9. Method according to one of Patent Claims 1 to 8, **characterized in that** the hard mask (8) is approximately between 100 nm and 300 nm thick.

10. Method according to one of Patent Claims 1 to 9, **characterized in that** the first and second passivation layers (5, 7) are each approximately 20 nm thick.

11. Method according to one of Patent Claims 1 to 10, **characterized in that** a third passivation layer (11) is applied.

12. Method according to one of Patent Claims 1 to 11, **characterized in that** a second insulating layer (12) is applied.

13. Method according to Patent Claim 12, **characterized in that** the second insulating layer (12) is chemical-mechanically polished.

14. Method according to one of Patent Claims 1 to 13, **characterized in that** the wafer is cooled during the sputtering.

15. Method according to one of Patent Claims 1 to 14, **characterized in that** nitrogen is fed in during the sputtering.

16. Method according to one of Patent Claims 1 to 15, **characterized in that** the structured, first insulating layer (2) is produced by reactive ion etching.

17. Method according to one of Patent Claims 1 to 16, **characterized in that** the layer of conductive material (6) is structured by heating the wafer and subsequent reactive ion etching.

18. Method according to one of Patent Claims 1 to 17, **characterized in that** the hard mask (8) is produced by means of the following steps:
- the hard mask material is deposited by means of CVD (Chemical Vapor Deposition),
- an antireflex layer (9) is applied,
- a photoresist mask (10) is applied,
- the hard mask material is removed by etching in the regions not covered by means of the photoresist mask (10), and
- the antireflex layer (9) and the photoresist mask (10) are removed.

## Revendications

1. Procédé de fabrication d'une structure conductrice pour un circuit intégré, dans lequel :
une première couche de passivation (5) est appliquée sur une première couche d'isolation structurée (2),
une couche de matériau conducteur (6) est appliquée sur la première couche de passivation (5),
une deuxième couche de passivation (7) est appliquée sur la couche de matériau conducteur (6),
un masque dur (8) est appliqué sur la deuxième couche de passivation (7),
la couche de matériau conducteur (6) est retirée dans les zones non recouvertes par le masque dur (8),
**caractérisé en ce que** :
la première couche de passivation (5) est retirée par crépitement dans les zones non recouvertes par le masque dur (8), et est à nouveau déposée, au moins en partie, sur la paroi latérale de la couche de matériau conducteur (6).

2. Procédé selon la revendication 1, **caractérisé en ce que** le retrait de la couche de matériau conducteur (6) est effectué par corrosion ionique réactive.

3. Procédé selon la revendication 1, **caractérisé en ce que** le retrait de la couche de matériau conducteur (6) est effectué par crépitement.

4. Procédé selon l'une des revendications 1 à 3, **caractérisé en ce que** la couche de matériau conducteur (6) contient du cuivre.

5. Procédé selon l'une des revendications 1 à 4, **caractérisé en ce que** l'épaisseur de couche du matériau conducteur (6) est comprise entre 300 nm et 500 nm.

6. Procédé selon l'une des revendications 1 à 5, **caractérisé en ce que** les couches de passivation (5, 7) contiennent du tantale ou du nitrure de tantale, ou les deux.

7. Procédé selon l'une des revendications 1 à 6, **caractérisé en ce que** la première couche d'isolation (2) contient un oxyde de silicium ou un matériau ayant une constante diélectrique qui est inférieure à celle d'oxyde de silicium.

8. Procédé selon l'une des revendications 1 à 7, **caractérisé en ce que** le masque dur (8) contient de l'oxyde de silicium, du nitrure de silicium ou du nitrure d'oxyde de silicium.

9. Procédé selon l'une des revendications 1 à 8, **caractérisé en ce que** l'épaisseur du masque dur (8) est approximativement comprise entre 100 nm et 300 nm.

10. Procédé selon l'une des revendications 1 à 9, **caractérisé en ce que** la première et la deuxième couche de passivation (5, 7) ont respectivement une épaisseur approximative de 20 nm.

11. Procédé selon l'une des revendications 1 à 10, **caractérisé en ce qu'**il est appliqué une troisième couche de passivation (11).

12. Procédé selon l'une des revendications 1 à 11, **caractérisé en ce qu'**il est appliqué une deuxième couche d'isolation (12).

13. Procédé selon la revendication 12, **caractérisé en ce que** la deuxième couche d'isolation (12) est polie par voie chimico-mécanique.

14. Procédé selon l'une des revendications 1 à 13, **caractérisé en ce que** la tranche est refroidie lors du crépitement.

15. Procédé selon l'une des revendications 1 à 14, **caractérisé en ce que** de l'azote est amené lors du crépitement.

16. Procédé selon l'une des revendications 1 à 15, **caractérisé en ce que** la première couche d'isolation structurée (2) est engendrée par corrosion ionique réactive.

17. Procédé selon l'une des revendications 1 à 16, **caractérisé en ce que** la structuration de la couche de matériau conducteur (6) est effectuée par chauffage de la tranche, et corrosion ionique réactive consécutive.

18. Procédé selon l'une des revendications 1 à 17, **caractérisé en ce que** le masque dur (8) est engendré par les étapes suivantes :
- application du matériau du masque dur au moyen de CVD (dépôt chimique en phase vapeur),
- application d'une couche anti-réflexion (9),
- application d'un masque de laque photosensible (10),
- élimination par gravure du matériau du masque dur dans les zones non recouvertes par le masque de laque photosensible (10), et
- retrait de la couche anti-réflexion (9) et du masque de laque photosensible (10).
